# EUROPÄISCHE PATENTSCHRIFT

(11) **EP 2 312 338 B1**
(45) Veröffentlichungstag und Bekanntmachung des Hinweises auf die Patenterteilung: **22.06.2016**
(21) Anmeldenummer: 10186674.7
(22) Anmeldetag: 06.10.2010
(51) Int. Cl.: G01V 3/10, H03K 17/95

(54) **Vorrichtung und Verfahren zur Detektion von elektrisch leitfähigen Gegenständen**
Method and device for detecting electrically conductive objects
Dispositif et procédé de détection d'objets conducteurs d'électricité

(30) Priorität: 19.10.2009 DE 102009049821
(43) Veröffentlichungstag der Anmeldung: 20.04.2011
(73) Patentinhaber: iControls, k.s., 85106 Bratislava (SK)
(72) Erfinder: Schmidt, Ralf Philipp, 67251, Freinsheim (DE)
(74) Vertreter: Weickmann & Weickmann PartmbB

(56) Entgegenhaltungen:
- WO-A2-01/71387
- DE-A1-102004 047 190

## Beschreibung

Die Erfindung betrifft eine Vorrichtung zur Detektion von elektrisch leitfähigen Gegenständen.

Aus der DE 41 02 542 A1 ist ein induktiver Nährungsschalter bekannt. Dieser induktive Nährungsschalter enthält einen Oszillator, der ein magnetisches Wechselfeld erzeugt und der bei Eindringen eines Auslösers in das Wechselfeld seinen Schwingungszustand ändert, was eine Auswerteschaltung zur Gewinnung eines Schaltsignals zur Ansteuerung eines Lastschalters nutzt. Die erfassbare Änderung des Schwingungszustands ist sowohl von materialtypischen Eigenschaften des Auslösers sowie dessen Abstand und dessen Position relativ zum dem Schalter abhängig. Diese Schalter reagieren somit relativ unspezifisch auf verschiedene Materialien und im Wesentlichen nur auf den Abstand zwischen dem Auslöser und dem Schalter.

Aus der DE 39 34 593 C2 ist ein Sensor bekannt, bei dem an die Primärspule ein dreiecksförmiges Signal angelegt wird, so dass gemäß dem Induktionsgesetz am Ausgang der Sekundärspule ein Rechtecksignal mit der Frequenz des Dreiecksignals erzeugt wird. Diese Variante dient dazu, einen Sensor zu entwerfen, der ein sicheres Signal abgibt. Dies wird durch das kontinuierliche Ansteigen beziehungsweise Abfallen gemäß dem dreiecksförmigen Signal erreicht.

Weiter ist aus der EP 0 936 741 A1 ein induktiver Nährungsschalter bekannt, der eine einzelne Spule verwendet, mit der mittels eines Sendestromimpulses in dem zu erfassenden Körper eine Induktionsspannung erzeugt wird, die einen Strom in dem Körper verursacht, dessen Abklingen nach dem Ende des Stromimpulses in der Spule Spannung induziert, die entsprechend verarbeitet werden kann. Die Sendestromimpulse liegen im Bereich zwischen 100 µs und 200 µs. Bei diesem Verfahren wird ein und dieselbe Spule für das Erzeugen eines Wirbelstroms als auch für das Erfassen des abklingenden Wirbelstroms verwendet. Ein Metallgehäuse für diesen Sensor muss nicht-ferromagnetisch sein und einen relativ hohen spezifischen elektrischen Widerstand aufweisen.

Aus WO 01/71387 A2 ist ein im Zeitbereich arbeitender elektromagnetischer Metalldetektor zum Aufspüren von Metallgegenständen im Erdreich bekannt. Der Metalldetektor umfasst eine von einem Rechteckimpulssignal gespeiste Sendespule und zwei im Bereich des von der Sendespule erzeugten Magnetfelds im Abstand voneinander angeordnete Empfangsspulen. Eine elektronische Auswerteschaltung spricht auf die Differenz der in den Empfangsspulen induzierten Induktionsspannungen an und detektiert den Metallgegenstand abhängig vom zeitlichen Verlauf der Abfallflanke, mit der die Induktionsspannungen nach dem Ende des die Sendespule erregenden Rechteckimpulses abnehmen. Bei einem solchen Metalldetektor ist die Detektion des Metallgegenstands vom Abstand zwischen den Spulen und dem Gegenstand abhängig, was das Erkennen des Gegenstands erschwert.

Aufgabe der vorliegenden Erfindung ist es, eine Vorrichtung zu schaffen, mit der spezifische Besonderheiten des zu erfassenden Gegenstands, wie beispielsweise Materialeigenschaften, Materialzusammensetzungen oder Größe des Gegenstands detektierbar werden und dies vorzugsweise (weitgehend) unabhängig vom Abstand zwischen der Vorrichtung und dem Gegenstand.

Diese Aufgabe wird gelöst mit einer Vorrichtung nach Anspruch 1. Bevorzugte Ausführungsformen sind in den abhängigen Ansprüche offenbart.

Die Vorrichtung weist drei Spulen auf, von denen zwei zur Erzeugung von Magnetfeldern und eine zur Detektion einer Spannung oder umgekehrt eine zur Erzeugung des Magnetfeldes und zwei zur Detektion einer Induktionsspannung verwendet werden können. Die Vorrichtung weist weiter eine Elektronik auf, die (insbesondere) während, und/oder nach der Versorgung der magnetfelderzeugenden Spule mit einen Strompuls eine Induktionsspannung erfasst. Befindet sich ein elektrisch leitfähiger Gegenstand im Bereich des Magnetfeldes, erzeugt dies so ein detektierbares Signal in der erfassten Induktionsspannung. Je nach Materialeigenschaften und Größe des detektierten Gegenstandes, kann die erfasste Induktionsspannung spezifische Charakteristika aufweisen. Aus diesen kann auch auf das Material des Gegenstandes, die Materialzusammensetzung des Gegenstandes und/oder die Größe des Gegenstandes zurückgeschlossen werden.

Die erste und zweite Spule kann entgegengesetzt oder gleichsinnig gewickelt sein. Die beiden Spulen können räumlich voneinander getrennt sein. Durch eine entsprechende Verschaltung dieser Spulen können Magnetfelder mit entgegengesetzter Polung erzeugt werden. Die erste und zweite Spule können in Reihe geschaltet sein. Sie können aber auch (unabhängig voneinander) von jeweils einer Stromquelle gespeist sein.

Auf beiden Seiten des Spulensystems (umfassend die erste, zweite und dritte Spule) erzeugen elektrisch leitfähige Gegenstände Signalformen mit entgegengesetztem Vorzeichen, so dass sich gleiche Effekte auf beiden Seiten eliminieren.

Der Strompuls weist einen sprunghaften Anstieg und/oder ein sprunghaftes Abfallen auf wie beispielsweise bei einem Rechteckpuls. In einer bevorzugten Ausführungsform weist der Strompuls die Form eines Rechteckpulses auf und hat die Dauer zwischen 0,1 ns und 1 ms wie etwa zwischen 1 µs und 50 µs. Je kürzer der Strompuls ist bzw. je kürzer der Anstieg oder Abfall ist, desto höherfrequenter ist das Anregungsspektrum für den Wirbelstrom. Durch Anteile mit verschiedenen Frequenzen können insbesondere verschiedene Größenskalen des Gegenstandes unterschieden werden, als auch auf frequenzspezifische Materialeigenschaften und damit auf die Zusammensetzung des elektrisch leitfähigen Gegenstandes geschlossen werden. Die Anstiegszeit in der beispielsweise 90% des maximalen Stromwerts (des sprunghaften Anstiegs) erreicht werden kann und/oder die Abfallzeit, in der der Strom vom Ausgangswert des sprunghaften Abfalls auf 10 % davon abfällt kann kürzer als 0,2 oder 0,1 µs sein.

Die durch die erste und zweite Spule erzeugte Induktionswirkungen in der dritten Spule oder die durch die dritte Spule erzeugte Induktionswirkung in der ersten und zweiten Spule heben sich zumindest teilweise auf. Vorzugsweise geschieht dies zumindest zu 90% oder 99%. Die Kompensationswirkung kann so sein, dass bei Nichtvorhandensein eines zu detektierenden elektrisch leitfähigen Gegenstandes die erfasste Induktionsspannung im Wesentlichen Null ist. Dies führt zu einer hohen Sensitivität der Vorrichtung zur Detektion, da jedes Vorhandensein eines elektrisch leitfähigen Gegenstandes eine von Null verschiedene Induktionsspannung oder eine von einer Referenzspannung verschiedene Induktionsspannung ergibt.

Falls die in der ersten und zweiten Spule erzeugte Induktionsspannung erfasst wird, so sind diese beiden Spulen vorzugsweise so verschaltet, dass die Induktionsspannungen sich zumindest teilweise, vorzugsweise zu mindestens 90% oder 99%, kompensieren, wobei vorzugsweise die Kompensation so erfolgt, dass bei Nichtvorhandensein eines zu detektierenden elektrisch leitfähigen Gegenstandes sich die beiden Induktionsspannungen im Wesentlichen zu Null ergänzen.

Vorzugsweise wird der Verlauf der erzeugten Induktionsspannung zu verschiedenen Zeiten erfasst (zeitabhängige Erfassung), während und/oder nach dem Strompuls. So können für jeden Strompuls beispielsweise mehr oder weniger als 5, mehr oder weniger als 10 oder mehr oder weniger als 100 Messwerte erfasst werden.

In einer besonders bevorzugten Ausführungsform werden in dem zeitabhängig erfassten Verlauf der Induktionsspannung ein, zwei, drei oder mehr Maximal- und/oder Minimal- und/oder Wendepunkte und/oder Nulldurchgänge (charakteristische Punkte) der erfassten Induktionsspannung bestimmt. Als Kriterium zur Wertung der Detektion eines elektrisch leitfähigen Gegenstandes kann beispielsweise der zeitliche Abstand zwischen Maximal- und/oder Minimal- und/oder Wendepunkt und/oder einem Nulldurchgang bestimmt werden. Diese Signale haben den Vorteil, dass sie weitgehend unabhängig von dem Abstand zwischen der Vorrichtung und dem zu detektierenden elektrisch leitfähigem Gegenstand sind. Die Signalhöhe wird zwar bei verschiedenen Abständen verschieden sein, jedoch sind die Zeiten beispielsweise zwischen Maximal-/Minimal- und Nulldurchgang (weitgehend) abstandsunabhängig. Es können auch für einen Strompuls mehrere charakteristische Punkte bestimmt werden wie etwa ein Maximum und ein Minimum oder mehrere Maxima oder mehrere Minima oder mehrere Nulldurchgänge. Dabei können mehrere zeitliche Abstände zwischen mehreren (in diesem Fall mindestens drei) solcher charakteristischen Punkte bestimmt werden und/oder die Zeiten zwischen dem Start des Strompulses und den mehreren charakteristischen Punkten.

Auch die Dauer vom Beginn eines Strompulses bis zum Erreichen eines Maximal-/Minimalwerts oder eines Nulldurchgangs oder eines Wendepunkts können zur Charakterisierung des detektierten elektrisch leitfähigen Gegenstandes herangezogen werden.

Auch eine Unterscheidung zwischen kleinen und großen Gegenständen ist mit derartigen Kriterien möglich. So können beispielsweise durch Schweißspritzer entstandene Metallpartikel unterschieden werden von großen elektrisch leitfähigen Gegenständen wie beispielsweise Metallplatten, um eine Fehlfunktion der Sensoren beziehungsweise eine Verschmutzung derselben zu erkennen.

Zusätzlich oder Alternativ zu solchen zeitlich bestimmten Charakteristika können auch andere Charakteristika wie zum Beispiel Absolutwerte bei einem Maximal-/Minimal- oder Wendepunkt herangezogen werden.

Im Bereich der ersten oder zweiten Spule können ein, zwei oder mehr metallisch leitfähige Gegenstände als Bestandteil der Vorrichtung vorgesehen sein. Mit diesen/diesem ist ein Abgleichen der erzeugten Induktionsspannung möglich und/oder auch das Vorgeben eines Referenzgegenstandes. Zum Abgleichen der erzeugten Induktionsspannung kann beispielsweise eine Schraube oder Stift vorgesehen sein, die mehr oder weniger stark in den Bereich eines Magnetfelds hereinragt und so beispielsweise zum Nullabgleich der erzeugten Induktionsspannung eingesetzt werden kann. Für den Nullabgleich kann die Schraube oder der Stift verstellt werden, bis ein gewünschtes Signal (also z.B. ein auf Null abgeglichenes Signal) erzeugt wird. Für den Abgleich oder den Nulllabgleich ist vorzugsweise kein zu detektierender elektrisch leitfähiger Gegenstand vorhanden. Bei Vorhandensein einer elektrisch leitfähigen Störkontur (wie beispielsweise bedingt durch metallische Maschinenteile, in oder an die der Sensor ein-/angebaut wird), kann der Einfluss der metallischen Störkontur mit dem Nullabgleich reduziert bzw. eliminiert werden. Dadurch können Sensoren gleicher Bauart für verschiedene Einsatzzwecke (Einbauten) hergestellt werden, die dann je nach Verwendung bzw. ja nach der Störkontur dennoch auf Null abgeglichen werden können.

Auch kann mit einem solchen Gegenstand ein Referenzgegenstand geschaffen werden, so dass bei Vorhandensein eines identischen oder sehr ähnlichen zu detektierenden elektrisch leitfähigen Gegenstands ein Nullsignal erzeugt wird. Dies ist beispielsweise insbesondere für die Erkennung von bestimmten Münzen vorteilhaft. Nur dann, wenn der zu detektierende elektrisch leitfähige Gegenstand mehr oder weniger identisch mit dem vorgegebenen Referenzgegenstand ist, ergibt sich bei Anlegen des Strompulses ein Nullsignal beziehungsweise ein vorbekanntes Signal und bei Abweichen des detektierten elektrisch leitfähigen Gegenstandes von dem Referenzgegenstand ergibt sich ein von Null verschiedenes beziehungsweise von dem vorbekannten Signal abweichendes Signal, das entsprechend ausgewertet werden kann, um zu detektierende elektrisch leitfähige Gegenstände, also insbesondere Münzen, zu diskriminieren. Hierbei kann die erzeugte Induktionsspannung zu verschiedenen Zeiten erfasst werden oder auch nur zu einer bestimmten Zeit nach Anlegen oder Abschalten des Strompulses.

Falls ein Referenzgegenstand als Bestandteil der Vorrichtung vorgesehen ist, so kann ein Abgleich oder Nullabgleich mittels Schraube oder Stift oder eines zum Abgleichen geeigneten Gegenstandes erfolgen, sofern ein zu detektierender elektrischer leitfähiger Gegenstand vorhanden ist, der identisch zu den Referenzgegenstand ist und in der Testposition für zukünftige zu detektierende Gegenstände angeordnet ist.

Statt einer Münze können auch andere elektrisch leitfähige Gegenstände mit Referenzgegenständen verglichen werden. Dies betrifft beispielsweise solche Gegenstände, die abnutzen oder verschleißen und deren Abnutzungsgrad oder Verschleißzustand erfasst werden soll. Dazu kann ein nicht abgenutzter oder nichtverschlissener Gegenstand mit einem zu untersuchenden Gegenstand verglichen werden. So können beispielsweise Elektrodenkappen, die auf die Elektroden eines Schweißgeräts aufgesetzt werden und von Zeit zu Zeit beispielsweise durch Fräsen gesäubert werden, wodurch sie sich abnutzen, ausgemessen werden, wodurch der Abnutzungsgrad bestimmt wird.

Zur Beeinflussung der erzeugten Induktionsspannung können auch ein oder mehrere weitere Spulen vorgesehen sein, die beispielsweise zur Erzeugung eines Nullabgleichs dienen können. Die Spulen können mit der ersten und/oder zweiten Spule in Reihe oder parallel geschaltet sein oder getrennt z. B. an eine Stromquelle angeschlossen oder über einen Widerstand oder eine Schaltung kurzgeschlossen sein.

Die dritte Spule kann auch zweiteilig ausgeführt sein, wobei die dritte Spule dann zwei Spulenteile umfasst, von denen beispielsweise einer der ersten und der andere der zweiten Spule zugeordnet ist. Dabei können die beiden Spulenteile auf einen gemeinsamen oder auch jeder auf einen einzelnen Spulenkörper gewickelt sein. Die beiden Spulenteile sind beispielsweise in Reihe geschaltet. Die dritte Spule kann jedoch auch einteilig ausgeführt sein, also beispielsweise auf einen Spulenkörper gewickelt sein.

Vorzugsweise umfasst die Vorrichtung ein Metallgehäuseteil oder ein Vollmetallgehäuse. Damit ist es möglich, den Sensor auch in Umgebungen mit einer aggressiven Atmosphäre wie beispielsweise säure- oder laugenhaltigen Dämpfen einzusetzen.

Der Metallgehäuseteil bzw. das Vollmetallgehäuse können aus beliebigem Edelstahl oder auch Buntmetall gefertigt sein. Die Detektion ist durch Edelstahl oder auch durch Buntmetall hindurch möglich, wobei keine Einschränkung auf z.B. hochohmige Metalle besteht. Die Frontfläche des Sensors, also diejenige Fläche, die dem zu detektierenden Gegenstand bzw. dessen Erkennungsposition zugewandt ist, kann aus jedem Edelstahl oder aus Buntmetall gefertigt sein. Auch durch solche Materialien hindurch ist die Detektion von elektrisch leitfähigen Gegenständen möglich. Je nach Anwendung können aber die einen oder die anderen Metalle als Gehäuse(teil) bevorzugt sein, wobei die Auswahl des Metalls von der Art der Detektion abhängen kann und auch von den Umgebungsbedingungen des Sensors (umgebende Gase oder Flüssigkeiten, Temperatur; Druck, etc.)

Die Vorrichtung kann insbesondere als Nährungsschalter ausgebildet sein oder zur Erkennung von verschiedenen Materialien, zur Münzerkennung oder zur Erkennung des Abnutzungsgrads oder des Verschleißes von Gegenständen. Als Nährungsschalter kann die Vorrichtung unterbündig eingebaut werden, da die erkannten Signale von dem Schaltabstand unabhängig sein können. Ein unterbündiger Einbau erlaubt einen guten Schutz der Vorrichtung gegen Beschädigung.

Erfindungsgemäß kann somit auch eine Vorrichtung wie beispielsweise eine Maschine vorgesehen sein, die eine Vorrichtung zur Detektion von elektrisch leitfähigen Gegenständen umfasst, die unterbündig eingebaut ist.

Bei dem Verfahren zur Detektion von elektrisch leitfähigen Gegenständen wird ein Strompuls an eine erste und eine zweite Spule angelegt, wobei diese Magnetfelder mit entgegengesetzter Polung erzeugen, wodurch die in einer dritten Spule erzeugte Induktionsspannung erfasst wird.

Stattdessen ist es auch möglich, einen Strompuls an die dritte Spule anzulegen und die Erfassung der Induktionsspannung in der ersten und zweiten Spule vorzunehmen. Die Induktionsspannung wird vorzugsweise in einem Zeitbereich während und/oder nach dem Anlegen des Strompulses zur Detektion des elektrisch leitfähigen Gegenstandes erfasst. Der Strompuls umfasst einen sprunghaften Anstieg oder ein sprunghaftes Abfallen wie beispielsweise in Form eines Rechteckpulses.

Besondere Ausführungsformen der Erfindung werden anhand der beiliegenden Figuren erläutert. Dabei zeigt:
- Figur 1: verschiedene Möglichkeiten der Verschaltung der ersten, zweiten und dritten Spule;
- Figur 2: die erzeugten Magnetfelder;
- Figur 3: eine schematische Darstellung der Vorrichtung;
- Figur 4: Strom- und Spannungsverläufe;
- Figur 5: eine schematische Darstellung der Magnetfelder bei Vorhandensein eines elektrisch leitfähigen Gegenstandes;
- Figur 6: eine bevorzugte Variante der Vorrichtung in schematischer Darstellung und
- Figur 7a, 7b: eine alternative Bauform der Vorrichtung.

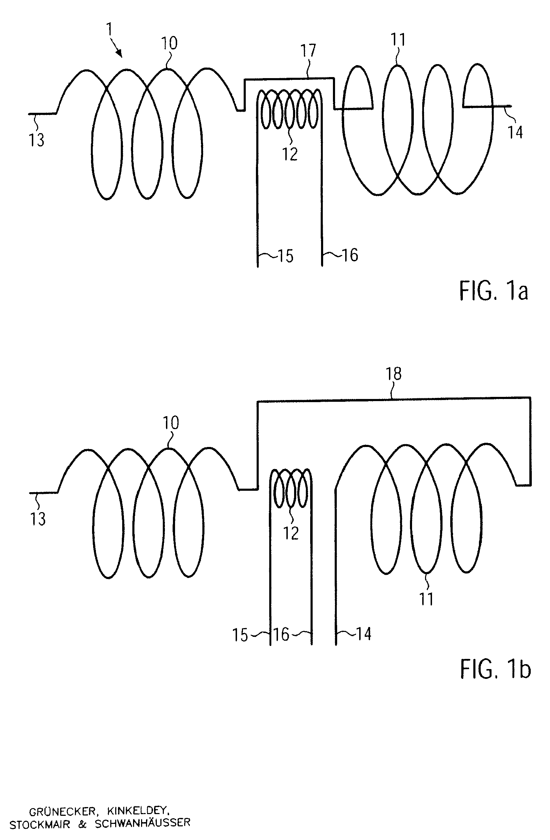

In Figur 1a ist eine Vorrichtung 1 zur Detektion eines elektrisch leitfähigen Gegenstandes schematisch gezeigt. Gezeigt ist eine erste Spule 10 und eine zweite Spule 11, die über die Verschaltung 17 miteinander in Reihe geschaltet sind. Die beiden Spulen sind gegensinnig gewickelt, so dass ein Strom, der von dem Anschluss 13 zu dem Anschluss 14 fließt, einmal ein nach rechts orientiertes Magnetfeld und einmal ein nach links orientiertes Magnetfeld erzeugt.

In dem Bereich zwischen den beiden Spulen 10 und 11 ist eine weitere Spule 12 angeordnet, mit der eine erzeugte Induktionsspannung erfasst werden kann. Diese kann zwischen den Anschlüssen 15 und 16 abgegriffen werden.

Die Spule 12 ist hier in dem Bereich angeordnet, der von den Magnetfeldern, die durch die Spule 10 und 11 erzeugt werden können, durchsetzt wird.

In Figur 1 b ist eine Variante gezeigt, bei der die Spulen 10 und 11 gleichsinnig gewickelt sind jedoch durch eine andere Verschaltung 18 der Strom in den beiden Spulen in verschiedenen (entgegengesetzten) Richtungen fließt, so dass auch hier Magnetfelder mit entgegengesetzter Polung erzeugt werden, falls ein Strom von Anschluss 13 zum Anschluss 14 fließt. Die Spulen können unabhängig voneinander an eine Stromversorgung angeschlossen sein. Dabei sind sie dann nicht in Reihe geschaltet.

Die Anzahl der Windungen in Figur 1a und 1b ist lediglich schematisch. Vorzugsweise ist die Anzahl der Windungen der Spulen 10 und 11 identisch oder variiert um nicht mehr als 5 % oder 1 %. Es können aber auch Varianten vorgesehen sein, bei denen sich die Wicklungszahlen um bis zu 50 % oder 80 % unterscheiden. Der Einfluss auf die generierten Signale kann durch entsprechende elektronische Kompensation oder durch einen entsprechenden Nullausgleich ausgeglichen werden.

Statt einen Strom an die Anschlüsse 13 und 14 zu legen, kann auch ein Strom zum Erzeugen eines Magnetfeldes an die Anschlüsse 15 und 16 der Spule 12 gelegt werden. In diesem Fall kann eine Induktionsspannung zwischen den Anschlüssen 13 und 14 abgegriffen werden. Für den Fall, dass das Magnetfeld der Spule 12 sich ungehindert und symmetrisch ausbreiten kann, wird die Induktionsspannung an den Anschlüssen 13 und 14 sich zu Null ergeben aufgrund der gegensinnigen Wicklungen in Figur 1a oder der gegensinnigen Schaltung in Figur 1b.

Die in den Spulen 10 und 11 erzeugte Induktionsspannung kann auch unabhängig voneinander erfasst werden. Dabei würde die Verschaltung 17 oder 18 wegfallen und die Induktionsspannung der beiden Spulen separat für jede Spule abgegriffen. Die jeweiligen Anschlüsse der beiden Spulen können einer Differenzschaltung zugeführt werden, die die Differenz der Induktionsspannungen als Ausgangssignal aufweist bzw. verstärkt, wie beispielsweise in Form eines Differenzverstärkers.

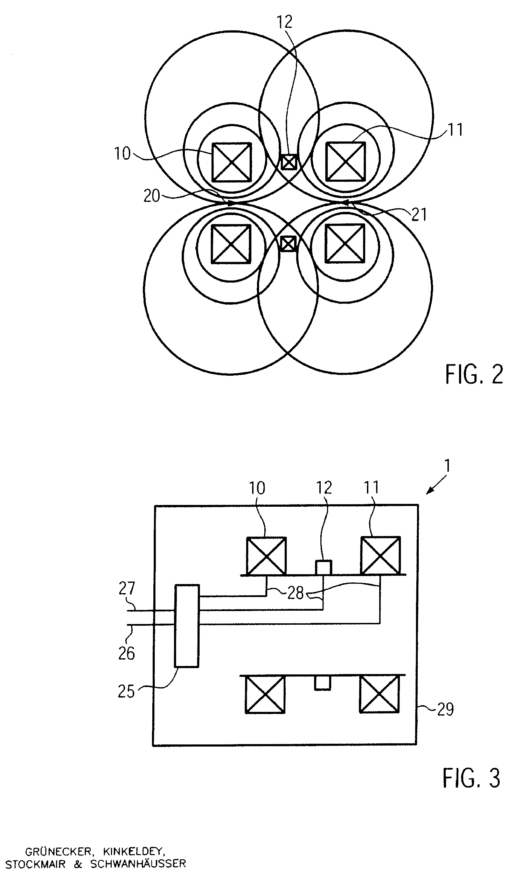

In Figur 2 ist die Vorrichtung 1 im Schnitt gezeigt. Zwischen den beiden Spulen 10 und 11 ist die Spule 12 angeordnet. In Figur 2 ist das durch die Spule 10 erzeugte Magnetfeld 20 dargestellt sowie das durch die Spule 11 erzeugte Magnetfeld 21, falls durch diese Spulen Strom geschickt wird.

Wie in Figur 2 zu erkennen, ist das Magnetfeld dieser beiden Spulen entgegengesetzt, so dass sich beim Erzeugen dieser Magnetfelder ohne weitere Einflüsse in der Spule 12 eine zu Null ergebende Instruktionsspannung einstellt.

In Figur 3 ist der Aufbau einer Vorrichtung 1 schematisch dargestellt. Neben den Spulen 10, 11 und 12 ist eine Elektronik 25 dargestellt, die die Spulen mit entsprechenden Anschlüssen 28 entweder mit Strom versorgt oder die entsprechenden Induktionsspannungen abgreifen kann.

Die Elektronik 25 kann mit externen Anschlüssen 26, 27 verbunden sein. Diese können zum Beispiel zur Stromversorgung der Vorrichtung 1 beziehungsweise der Elektronik 25 dienen oder zum Ausgeben eines Messsignals.

Die Spulen 10, 11 und 12 können auf einen Spulenkörper aufgewickelt sein, der nicht magnetisch ist oder auch weichmagnetisch ist, wie beispielweise ein Ferritkern.

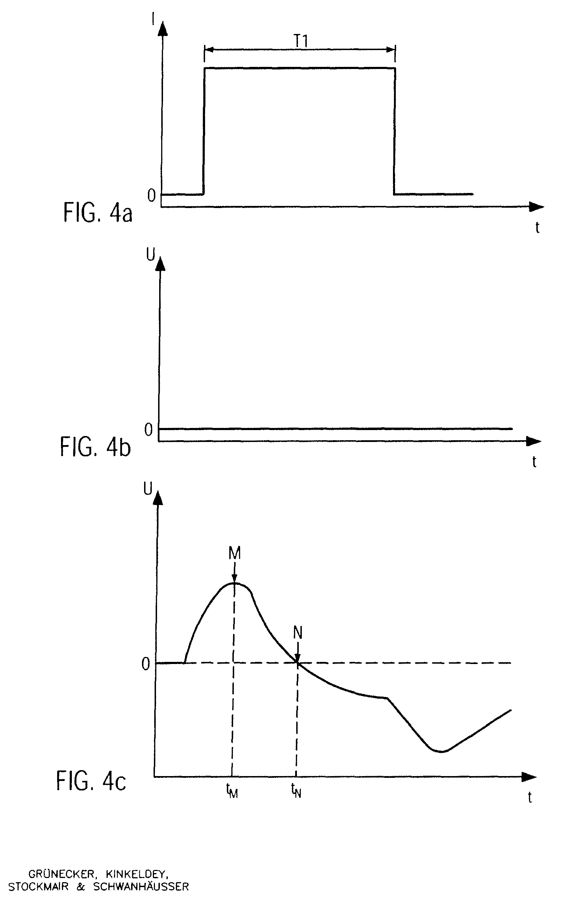

In Figur 4 ist ein Beispiel für den Strom- und Spannungsverlauf dargestellt. In Figur 4a ist ein rechteckiger Stromimpuls gezeigt, bei dem während der Zeit T1 ein Strom vorgegebener Stärke fließt. Dieser Strom fließt beispielsweise zwischen den Anschlüssen 13 und 14 der Spulenanordnung in Figur 1a und 1b oder auch zwischen den Anschlüssen 15 und 16 der Figur 1 a und 1 b.

Sofern kein zu detektierender elektrisch leitfähiger Gegenstand vorhanden ist, kann sich eine messbare Induktionsspannung ergeben, wie sie in Figur 4b dargestellt ist, nämlich ein durchbleibendes Nullsignal, das von dem Strompuls unbeeinflusst ist.

Bei Vorhandensein eines elektrisch leitfähigen Gegenstandes ergibt sich eine Induktionsspannung, wie sie beispielhaft in Figur 4c dargestellt ist. Während des Strompulses in der Zeit T1 kann die gemessene Induktionsspannung U ein zeitlich charakteristisches Profil aufweisen. Dieses Profil kann beispielsweise durch die Bestimmung eines Maximums M und eines Nulldurchgangs N oder auch weiterer charakteristischer Punkte wie etwa Wendepunkt oder ähnliches ausgewertet werden. Es kann beispielsweise zur Charakterisierung dieses Profils die Zeit Δt bestimmt werden, die den Zeitabstand zwischen dem Maximum M und dem Nulldurchgang N angibt, also Δt = t_{N} - t_{M}. Auch kann die Zeit vom Start des Strompulses bis zum Wendepunkt zur Charakterisierung des Profils bestimmt werden.

Der Induktionsspannungsverlauf kann auch statt eines Maximums ein Minimum aufweisen, wobei beispielsweise Δt sich aus der Zeitspanne zwischen dem Minimum und einem Nulldurchgang ergibt.

Neben der Bestimmung von Δt, wie in Figur 4c gezeigt, kann auch die Zeit vom Einsetzen des Strompulses bis zum Erreichen des Maximalwerts M bestimmt werden oder andere charakteristische Zeiten.

Auch der Absolutwert im Maximalpunkt der Spannung U kann zur Auswertung der Induktionsspannung berücksichtigt werden.

Auch ist es möglich, zu einer fest vorgegebenen Zeit nach dem Beginn des Strompulses oder zu mehrerer solcher Zeiten, die Induktionsspannung zu bestimmen und aus den Absolutwerten dieser Induktionsspannung oder aus dem Vorzeichen, das sich zu verschiedenen Zeiten ergibt, Rückschlüsse auf die Charakteristika des elektrisch leitfähigen Gegenstandes 30 zu ziehen.

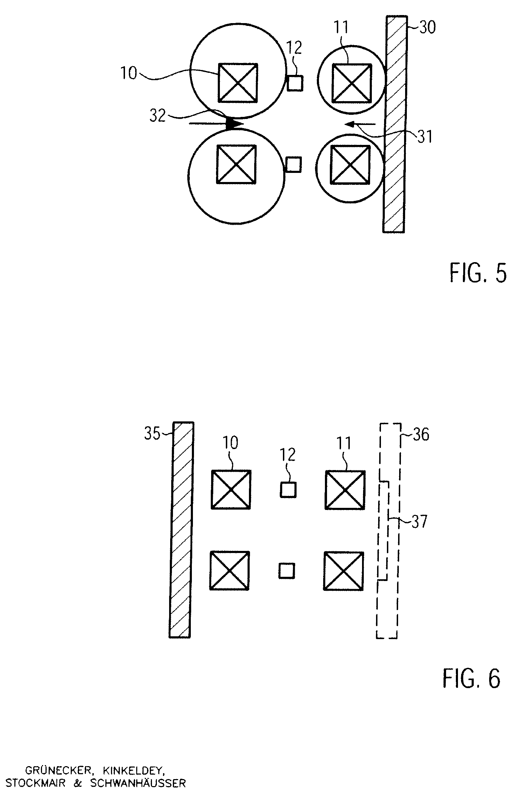

In Figur 5 ist dargestellt, dass das Magnetfeld 31 der Spule 11 durch das Vorhandensein eines zu detektierenden elektrisch leitfähigen Körpers 30 beeinflusst werden kann. Wie in Figur 5 dargestellt, ist der Pfeil 32 größer als der Pfeil 31. Der Pfeil 32 stellt das von der Spule 10 erzeugte magnetische Feld dar. Durch die unterschiedliche Beeinflussung der Magnetfelder 32 und 31 durch die Spulen 10 und 11 ergibt sich ein Symmetriebruch, der dazu führt, dass in der Spule 12 eine Induktionsspannung erzeugt wird. Die erzeugte Induktionsspannung in der Spule 12 weist typische Charakteristika (insbesondere charakteristische zeitliche Verläufe) auf, die auf die Beschaffenheit des Gegenstandes 30 schließen lassen.

Wie bereits vorher erwähnt, kann statt der Erzeugung der Magnetfelder durch die Spulen 10 und 11 das Magnetfeld auch durch die Spule 12 erzeugt werden, wobei dieses Magnetfeld aufgrund des Vorhandenseins des Gegenstandes 30 asymmetrisch ausfällt, so dass in der Spule 11 eine von der Spule 10 verschiedene Induktionsspannung erzeugt wird, die bei entsprechender Verschaltung (siehe Figur 1a, 1b) nicht zu einer völligen Kompensation beziehungsweise Aufhebung der beiden Induktionsspannungen führt sondern vielmehr zu einer von Null verschiedenen Induktionsspannung.

In Figur 6 ist die Vorrichtung 1 zur Detektion eines elektrisch leitfähigen Gegenstandes gezeigt, wobei ein Referenzgegenstand 35 links bei der Spulenanordnung vorgesehen ist. Wird ein identischer oder nahezu gleichartiger elektrisch leitfähiger Gegenstand 36 am rechten Ende der Spulenanordnung angeordnet, so ergibt sich bei Anlegen eines Strompulses an die Spulen 10 und 11 eine Induktionsspannung durch die Spule 12, die sich zu Null ergibt. Wird jedoch ein andersartig elektrisch leitfähiger Gegenstand, wie beispielsweise durch die gestrichelte Linie 37 dargestellt, an die Spulenanordnung angelegt, so wird sich eine von Null verschiedene Induktionsspannung ergeben, die darauf hinweist, das der zu detektierende elektrisch leitfähige Gegenstand nicht identisch oder ähnlich zu dem elektrisch leitfähigem Gegenstand 35 ist.

Durch die Vorgabe eines elektrisch leitfähigen Referenzgegenstandes 35 kann ein zu untersuchender elektrisch leitfähiger Gegenstand 36 auf eine Vielzahl von Charakteristika hin mit dem Referenzgegenstand verglichen werden. Jede Abweichung in der Materialzusammensetzung, Größe, etc. führt zu einer von Null verschiedenen Induktionsspannung. Bei Unterschieden der Gegenstände 35 und 36 können auch zeitlich charakteristische Verläufe der Induktionsspannung auftreten. Die Induktionsspannung kann auch Maxima und/oder Minima und/oder Nulldurchgänge oder Wendepunkte aufweisen, die erkannt und ausgewertet werden können, um den Unterschied zwischen den zwei Gegenständen zu quantifizieren. Dabei können sowohl Zeitabstände zwischen Maxima und oder Minima und/oder Nulldurchgängen und/oder Wendepunkten und/oder die Werte der Spannung bei diesen Punkten ausgewertet werden. Auch die Zeit vom Auftreten eines Maxima/Minima/Nulldurchgangs/Wendepunkts ab dem Anlegen des Strompulses kann ausgewertet werden.

Sind die beiden Gegenstände 35 und 36 identisch und symmetrisch zu der Spulenanordnung angeordnet und sind die Spulen 35 identisch und symmetrisch angeordnet, so wird sich bei Anlegen eines Strompulses gleicher Amplitude an die beiden Spulen ein zeitlich durchgängiges Nullsignal geben. Jede Abweichung davon deutet dann auf einen Unterschied zwischen den beiden Gegenständen hin. Statt der Erzeugung eines Nullsignals kann die Spulenanordnung oder die Stromversorgung der Spulen so sein, dass sich auch bei identischen Gegenständen 35, 36 ein zeitlicher Verlauf der Induktionsspannung ergibt, der von Null abweicht (Referenz). Jede weitere Abweichung von einer solchen Referenz einer erfassten Induktionsspannung deutet dann aber auf eine Verschiedenheit der Gegenstände hin.

Durch den Vergleich von zwei Gegenständen 35, 36 ist eine Falschgeldprüfung von Münzen oder auch die Bestimmung eines Abnutzungsgrads oder Verschleißgrads von sich abnutzenden oder verschleißenden Gegenständen möglich. Damit können z.B. auch der Abnutzungsgrad von Elektrodenschweißkappen untersucht werden.

Wie vorab erwähnt, kann auch ein Messvorgang dadurch durchgeführt werden, dass der Strom an die Spule 12 gelegt wird, und die Induktionsspannung, die sich in den Spulen 10 und 11 einstellt, ermittelt wird.

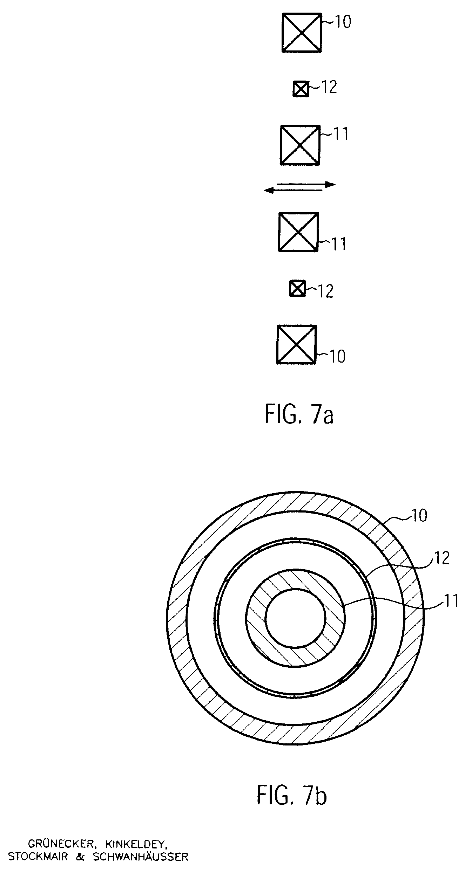

In Figur 7a und 7b ist eine alternative Bauform der Vorrichtung zur Detektion von elektrisch leitfähigen Gegenständen dargestellt, bei der die Spule 11 innerhalb der Spule 10 vorgesehen ist und die Spule 12 zwischen den Spulen 10 und 11 angeordnet ist. Die verschiedenen Spulen sind hierbei in einer radial nach außen laufenden Richtung hintereinander angeordnet. Die zweite und dritte Spule können hierbei ganz oder teilweise innerhalb des von der ersten Spule umgebenen Raumbereichs vorgesehen sein. Die Figur 7a zeigt einen Schnitt durch die in Fig. 7b in Draufsicht dargestellte Spulenanordnung.

Auch in dieser Konfiguration ist eine Detektion von elektrisch leitfähigen Gegenständen möglich mit denselben Unterscheidungsmöglichkeiten.

Die Spulen 10, 11 und 12 können in allen Figuren rund oder auch eckig sein, so dass eine Windung beispielsweise kreisförmig oder rechteckig oder quadratisch ausgebildet ist.

## Patentansprüche

1. Vorrichtung zur Detektion von elektrisch leitfähigen Gegenständen, umfassend:
- eine Elektronik (25) mit ersten Anschlüssen zur Abgabe wenigstens eines Stromimpulses mit sprunghaftem Anstieg und/oder sprunghaftem Abfall und mit zweiten Anschlüssen zum Abgreifen einer Induktionsspannung, wobei die Elektronik (25) dazu ausgebildet ist den zeitabhängigen Verlauf der Induktionsspannung während und/oder nach dem Stromimpuls zu erfassen
- eine Spulenanordnung mit wenigstens drei Spulen (10, 11, 12), von denen entweder
a) eine erste Spule (10) und eine zweite Spule (11) in der Weise angeordnet und mit den ersten Anschlüssen verbunden sind, dass die erste Spule (10) und die zweite Spule (11) dazu ausgebildet sind im Bereich einer mit den zweiten Anschlüssen verbundenen dritten Spule (12) einander entgegengesetzt gepolte Magnetfelder zu erzeugen und die Elektronik (25) dazu ausgebildet ist, den zeitabhängigen Verlauf der in der dritten Spule (12) erzeugten Induktionsspannung zu erfassen oder von denen
b) eine erste Spule (10) und eine zweite Spule (11) in der Weise angeordnet und mit den zweiten Anschlüssen verbunden sind, dass das von einer mit den ersten Anschlüssen verbundenen dritten Spule (12) erzeugte Magnetfeld in der ersten Spule (10) und der zweiten Spule (11) Induktionsspannungen erzeugt und die Elektronik (25) dazu ausgebildet ist, den zeitabhängigen Verlauf der Differenzspannung der Induktionsspannungen der ersten Spule (10) und der zweiten Spule (11) zu erfassen wobei die Elektronik (25) dazu ausgebildet ist, zur Detektion des Gegenstands auf ein charakteristisches Profil des zeitabhängigen Spannungsverlaufs anzusprechen
**dadurch gekennzeichnet, dass** die Elektronik dazu ausgebildet ist hierzu während und/oder nach dem Stromimpuls wenigstens einen charakteristischen Punkt des zeitabhängigen Spannungsverlaufs in Form wenigstens eines Maximalpunkts und/oder wenigstens eines Minimalpunkts und/oder wenigstens eines Wendepunkts und/oder wenigstens eines Nulldurchgangs zu erfassen und zur Bestimmung des Profils den zeitlichen Abstand zwischen einem oder mehreren charakteristischen Punkten und/oder zwischen dem Start des Stromimpulses und wenigstens einem der charakteristischen Punkte zu ermitteln.

2. Vorrichtung nach Anspruch 1, **dadurch gekennzeichnet, dass** der Stromimpuls ein Rechteckimpuls mit einer Dauer zwischen 0,1 ns und 1 ms ist.

3. Vorrichtung nach Anspruch 2, **dadurch gekennzeichnet, dass** der Rechteckimpuls eine Dauer zwischen 1 µs und 50 µs hat.

4. Vorrichtung nach einem der Ansprüche 1 bis 3, **dadurch gekennzeichnet, dass** bei mit den zweiten Anschlüssen der Elektronik (25) verbundener dritter Spule (12) die erste Spule (10) und die zweite Spule (11) so ausgebildet sind, dass die von den Magnetfeldern der ersten Spule (10) und der zweiten Spule (11) in der dritten Spule (12) induzierten Induktionsspannungen sich zumindest teilweise, insbesondere zu mindestens 90 % oder 99 % kompensieren.

5. Vorrichtung nach einem der Ansprüche 1 bis 3, **dadurch gekennzeichnet, dass** bei mit den ersten Anschlüssen der Elektronik (25) verbundener dritten Spule (12) die erste Spule (10) und die zweite Spule (11) so ausgebildet sind, dass sich die in der ersten Spule (10) und der zweiten Spule (11) induzierten, von der Elektronik (25) als Differenzspannung erfassten Induktionsspannungen zumindest teilweise, insbesondere zu mindestens 90 % oder 99 % kompensieren.

6. Vorrichtung nach Anspruch 4 oder 5, **dadurch gekennzeichnet, dass** sich die Induktionsspannungen bei Nichtvorhandensein des zu detektierenden Gegenstands im Wesentlichen zu Null kompensieren.

7. Vorrichtung nach einem der Ansprüche 1 bis 6, **dadurch gekennzeichnet, dass** im Bereich entweder der ersten Spule (10) oder der zweiten Spule (11) zum Abgleichen der erzeugten Induktionsspannung oder zur Reduzierung oder Eliminierung des Störeinflusses einer elektrisch leitfähigen Störkontur oder als Referenzgegenstand ein metallisch leitfähiger Gegenstand (35) als Bestandteil der Vorrichtung vorgesehen ist.

8. Vorrichtung nach einem Ansprüche 1 bis 7, **dadurch gekennzeichnet, dass** zum Beeinflussen der erzeugten Induktionsspannung eine oder mehrere weitere Spulen vorgesehen sind.

9. Vorrichtung nach einem Ansprüche 1 bis 8, **dadurch gekennzeichnet, dass** die Vorrichtung ein Metallgehäuseteil oder ein Vollmetallgehäuse (29) aus Buntmetall oder Elektrostahl umfasst, wobei das Vollmetallgehäuse (29) zumindest die erste (10), die zweite (11) und die dritte (12) Spule umschließt.

10. Vorrichtung nach Anspruch 9, **dadurch gekennzeichnet, dass** das Vollmetallgehäuse (29) zumindest eine Teil der Elektronik (25) oder die ganze Elektronik (25) umschließt.

11. Vorrichtung nach einem der Ansprüche 1 bis 10, **dadurch gekennzeichnet, dass** die Vorrichtung als Näherungsschalter oder als Materialienerkennungsvorrichtung oder als Münzerkennungsvorrichtung oder als Vorrichtung zum Erfassen eines Abnutzungs- oder Verschleißgrades ausgebildet ist.

## Claims

1. Device for detecting electrically conductive objects, comprising:
- an electronic system (25) comprising first terminals for delivering at least one current pulse having a sudden rise and/or sudden drop, and comprising second terminals for tapping an induction voltage, the electronic system (25) being designed to record the time-dependent curve of the induction voltage during and/or following the current pulse,
- an arrangement of coils comprising at least three coils (10, 11, 12), of which
a) a first coil (10) and a second coil (11) are arranged and connected to the first terminals such that the first coil (10) and the second coil (11) are designed to generate magnetic fields having opposite polarity in the region of a third coil (12) connected to the second terminals, and the electronic system (25) is designed to record the time-dependent curve of the induction voltage generated in the third coil (12), or of which
b) a first coil (10) and a second coil (11) are arranged and connected to the second terminals such that the magnetic field generated by a third coil (12) connected to the first terminals generates induction voltages in the first coil (10) and the second coil (11), and the electronic system (25) is designed to record the time-dependent curve of the differential voltage of the induction voltages of the first coil (10) and the second coil (11), the electronic system (25) being designed to respond to a characteristic profile of the time-dependent voltage curve in order to detect the object, **characterised in that**, for this purpose, the electronic system is designed to record, during and/or following the current pulse, at least one characteristic point on the time-dependent voltage curve in the form of at least one maximum point and/or at least one minimum point and/or at least one inflection point and/or at least one zero crossing, and to identify the time interval between one or more characteristic points and/or between the start of the current pulse and at least one of the characteristic points in order to determine the profile.

2. Device according to claim 1, **characterised in that** the current pulse is a rectangular pulse having a duration of between 0.1 ns and 1 ms.

3. Device according to claim 2, **characterised in that** the rectangular pulse has a duration of between 1 µs and 50 µs.

4. Device according to any of claims 1 to 3, **characterised in that**, if there is a third coil (12) which is connected to the second terminals of the electronic system (25), the first coil (10) and the second coil (11) are designed such that the induction voltages induced in the third coil (12) by the magnetic fields of the first coil (10) and the second coil (11) are at least partially neutralised, in particular by at least 90 % or 99 %.

5. Device according to any of claims 1 to 3, **characterised in that**, if there is a third coil (12) which is connected to the first terminals of the electronic system (25), the first coil (10) and the second coil (11) are designed such that the induction voltages that are induced in the first coil (10) and the second coil (11) and recorded as the differential voltage by means of the electronic system (25) are at least partially neutralised, in particular by at least 90 % or 99 %.

6. Device according to either claim 4 or claim 5, **characterised in that** the induction voltages are neutralised substantially to zero if the object to be detected is not present.

7. Device according to any of claims 1 to 6, **characterised in that** a conductive metal object (35) is provided as part of the device in the region of either the first coil (10) or the second coil (11) in order to compensate for the generated induction voltage or in order to reduce or eliminate the disturbance of an electrically conductive interference contour or to act as a reference object.

8. Device according to any of claims 1 to 7, **characterised in that** one or more additional coils are provided in order to influence the generated induction voltage.

9. Device according to any of claims 1 to 8, **characterised in that** the device comprises a metal housing part or a full metal housing (29) made of nonferrous heavy metal or electric steel, the full metal housing (29) enclosing at least the first (10), the second (11) and the third (12) coil.

10. Device according to claim 9, **characterised in that** the full metal housing (29) encloses at least some of the electronic system (25) or the entire electronic system (25).

11. Device according to any of claims 1 to 10, **characterised in that** the device is designed as a proximity sensor, or as a material detection device, or as a coin detection device, or as a device for detecting a degree of corrosion or wear.

## Revendications

1. Dispositif pour la détection d'objets électroconducteurs comprenant :
- une électronique (25) avec des premiers raccords pour l'émission d'au moins une impulsion de courant avec une forte montée et/ou une forte baisse et avec des seconds raccords pour prélever une tension d'induction, l'électronique (25) étant réalisée afin de
détecter la courbe dépendant du temps de la tension d'induction pendant et/ou après l'impulsion de courant
- un agencement de bobine avec au moins trois bobines (10, 11, 12) dont
a) une première bobine (10) et une deuxième bobine (11) sont agencées et sont reliées aux premiers raccords de telle manière que la
première bobine (10) et la deuxième bobine (11) soient réalisées afin de générer
dans la zone d'une troisième bobine (12) reliée aux seconds raccords, des champs magnétiques à pôles opposés et l'électronique (25)
est réalisée
afin de détecter la courbe dépendant du temps de la tension d'induction générée dans la troisième bobine (12) ou dont
b) une première bobine (10) et une deuxième bobine (11) sont agencées et sont reliées aux seconds raccords de telle manière que le champ magnétique généré par une troisième bobine (12) reliée aux premiers raccords dans la première bobine (10) et la deuxième bobine (11) génère des tensions d'induction et l'électronique (25) est réalisée afin de
détecter la courbe dépendant du temps de la tension différentielle des tensions d'induction de la première bobine (10) et de la deuxième bobine (11)
dans lequel l'électronique (25) est réalisée afin de
réagir pour la détection de l'objet au profil caractéristique de la courbe de tension dépendant du temps, **caractérisé en ce que** l'électronique est réalisée afin de détecter
à cet effet pendant et/ou après l'impulsion de courant, au moins un point caractéristique de la courbe de tension dépendant du temps sous la forme d'au moins un point maximal et/ou au moins un point minimal et/ou au moins un point de retour et/ou au moins un passage par zéro
et de déterminer pour la détermination du profil l'intervalle temporel entre un ou plusieurs points caractéristiques et/ou entre le démarrage de l'impulsion de courant et au moins un des points caractéristiques.

2. Dispositif selon la revendication 1, **caractérisé en ce que** l'impulsion de courant est une impulsion rectangulaire avec une durée entre 0,1 ns et 1 ms.

3. Dispositif selon la revendication 2, **caractérisé en ce que** l'impulsion rectangulaire a une durée entre 1 µs et 50 µs.

4. Dispositif selon l'une quelconque des revendications 1 à 3, **caractérisé en ce que** pour la troisième bobine (12) reliée aux seconds raccords de l'électronique (25), la première bobine (10) et la deuxième bobine (11) sont réalisées de sorte que les tensions d'induction induites par les champs magnétiques de la première bobine (10) et de la deuxième bobine (11) dans la troisième bobine (12) se compensent au moins en partie en particulier à au moins 90 ou 99 %.

5. Dispositif selon l'une quelconque des revendications 1 à 3, **caractérisé en ce que** pour la troisième bobine (12) reliée aux premiers raccords de l'électronique (25), la première bobine (10) et la deuxième bobine (11) sont réalisées de sorte que les tensions d'induction induites dans la première bobine (10) et la deuxième bobine (11), détectées par l'électronique (25) comme tension différentielle, se compensent au moins en partie en particulier à au moins 90 ou 99 %.

6. Dispositif selon la revendication 4 ou 5, **caractérisé en ce que** les tensions d'induction se compensent sensiblement à zéro en cas d'absence de l'objet à détecter.

7. Dispositif selon l'une quelconque des revendications 1 à 6, **caractérisé en ce que** dans la zone de la première bobine (10) ou de la deuxième bobine (11) pour ajuster la tension d'induction générée ou pour réduire ou éliminer l'influence perturbatrice d'un contour perturbateur électroconducteur ou comme objet de référence, un objet métalloconducteur (35) est prévu comme élément du dispositif.

8. Dispositif selon l'une quelconque des revendications 1 à 7, **caractérisé en ce que** pour l'influence de la tension d'induction générée, une ou plusieurs autres bobines sont prévues.

9. Dispositif selon l'une quelconque des revendications 1 à 8, **caractérisé en ce que** le dispositif comporte une partie de boîtier métallique ou un boîtier métallique plein (29) en métal non ferreux ou acier électrique, le boîtier métallique plein (29) entourant au moins la première (10), la deuxième (11) et la troisième (12) bobine.

10. Dispositif selon la revendication 9, **caractérisé en ce que** le boîtier métallique plein (29) entoure au moins une partie de l'électronique (25) ou l'électronique entière (25).

11. Dispositif selon l'une quelconque des revendications 1 à 10, **caractérisé en ce que** le dispositif est réalisé comme détecteur de proximité ou comme dispositif de détection de matériaux ou comme dispositif de détection de monnaie ou comme dispositif pour la détection d'un degré de détérioration ou d'usure.
